Europäisches Patentamt

European Patent Office

Office européen des brevets

(11) Veröffentlichungsnummer: **0 236 967**
**B1**

# (12) EUROPÄISCHE PATENTSCHRIFT

(45) Veröffentlichungstag der Patentschrift:
13.06.90

(21) Anmeldenummer: 87103182.9

(22) Anmeldetag: 06.03.87

(51) Int. Cl.⁵: **H03K 17/06**, H01L 27/06

(54) Schaltungsanordnung zum Ansteuern eines mit sourceseitiger Last verbundenen Mosfet.

(30) Priorität: 11.03.86 DE 3608023

(43) Veröffentlichungstag der Anmeldung:
16.09.87 Patentblatt 87/38

(45) Bekanntmachung des Hinweises auf die Patenterteilung:
13.06.90 Patentblatt 90/24

(84) Benannte Vertragsstaaten:
DE FR GB IT SE

(56) Entgegenhaltungen:
EP-A- 0 133 642
DE-A- 2 547 220
US-A- 3 271 640
US-A- 3 667 115

PATENT ABSTRACTS OF JAPAN, Band 8,
Nr. 213 (E-269)[1650], 28. September 1984; &
JP-A-59 97 223 (NISSAN JIDOSHA K.K.) 05-06-1984
PATENT ABSTRACTS OF JAPAN, Band 7,
Nr. 200 (E-196)[1345], 3. September 1983; &
JP-A-58 99 032 (TOKYO SHIBAURA DENKI
K.K.) 13-06-1983

(73) Patentinhaber: Siemens Aktiengesellschaft,
Wittelsbacherplatz 2, D-8000 München 2(DE)

(72) Erfinder: Tihanyi, Jenö, Dr. Ing., Windeckstrasse 1 d,
D-8000 München 70(DE)

**Beschreibung**

Die Erfindung bezieht sich auf eine Schaltungsanordnung zum Ansteuern eines MOSFET mit einer Last, die zwischen den Sourceanschluß und Masse liegt, mit den Merkmalen:

a) Der Drainanschluß des MOSFET ist mit einer Ausgangsklemme verbunden,

b) die Ausgangsklemme ist mit einem Pol einer Betriebsspannungsquelle verbindbar,

c) zwischen dem Gateanschluß des MOSFET und Masse liegt ein Schalter,

d) in der Gatezuleitung des MOSFET liegen zwei in Reihe geschaltete Dioden,

e) die Reihenschaltung ist mit einem Mittelabgriff versehen, der mit einem Anschluß eines Kondensators versehen ist,

f) der andere Anschluß ist mit einer ersten Anschlußklemme verbunden, an die eine getaktete Gleichspannung anlegbar ist.

Eine solche Schaltungsanordnung ist beipsielsweise in der Zeitschrift "Siemens Components" 22 (1984), Heft 4, Seiten 169 ff. beschrieben worden. Sie geht davon aus, daß sich das Sourcepotential eines MOSFET mit sourceseitiger Last (Sourcefolger) beim Einschalten ändert. Soll der MOSFET eingeschaltet bleiben, so muß das Gatepotential immer mindestens um die Einsatzspannung höher als das Sourcepotential sein. Bei voll durchgeschaltetem MOSFET muß das Gatepotential daher mindestens um die Einsatzspannung über dem Drainpotential liegen. Mit der bekannten Schaltung ist es möglich, einen Sourcefolger auch dann sicher im leitenden Zustand zu halten, wenn keine höhere Spannung als die Drain-Sourcespannungsquelle (Betriebsspannung) zur Verfügung steht. Die Schaltung macht dabei von einer Spannungsverdopplerschaltung Gebrauch, bei der der Kondensator über eine der Dioden auf die Betriebsspannung aufgeladen wird. Zusätzlich wird dem Kondensator eine getaktete Gleichspannung zugeführt, die den Kondensator auf eine Spannung aufkädt, die größer ist als die Betriebsspannung. Der Kondensator entlädt sich über die zweite Diode in die Gate-Source-Kapazität des MOSFET und steuert ihn leitend.

Der Erfindung liegt die Aufgabe zugrunde, eine Schaltungsanordnung der genannten Art so weiterzubilden, daß sie auf einem Halbleiterchip integrierbar ist. Dabei soll insbesondere für die beiden Dioden eine integrierbare Ausführung geschaffen werden.

Diese Aufgabe wird gelöst durch die Merkmale:

g) Die Reihenschaltung der Dioden ist über die Drain-Sourcestrecke eines zweiten MOSFET mit der genannten Ausgangsklemme verbunden,

h) der zweite MOSFET ist vom dem ersten MOSFET entgegengesetzten Kanaltyp und sourceseitig mit der Ausgangsklemme verbunden,

i) zwischen Sourceanschluß und dem Gateanschluß des zweiten MOSFET liegt ein Widerstand,

k) zwischen Gateanschluß des zweiten MOSFET und Masse liegt die Source-Drainstrecke eines dritten MOSFET,

l) der Gateanschluß des dritten MOSFET ist mit einer zweiten Eingangsklemme verbunden,

m) der Schalter wird durch einen vierten MOSFET vom dem ersten MOSFET entsprechenden Kanaltyp gebildet,

n) der Gateanschluß des vierten MOSFET ist mit einer dritten Eingangsklemme verbunden,

o) an die zweite und dritte Eingangsklemme sind einander inverse logische Signale anlegbar.

Die integrierte Schaltung der erwähnten Dioden einschließlich deren Weiterbildungen sind Gegenstand der Unteransprüche.

Die Erfindung wird anhand eines Ausführungsbeispiels in Verbindung mit den Fig. 1 bis 3 näher erläutert. Es zeigen:

Fig. 1 die Schaltungsanordnung gemäß der Erfindung,

Fig. 2 den zeitlichen Verlauf der Spannungen an den drei Eingangsklemmen und den zeitlichen Verlauf des Laststroms,

Fig. 3 die integrierte Schaltungsanordnung der erwähnten Dioden.

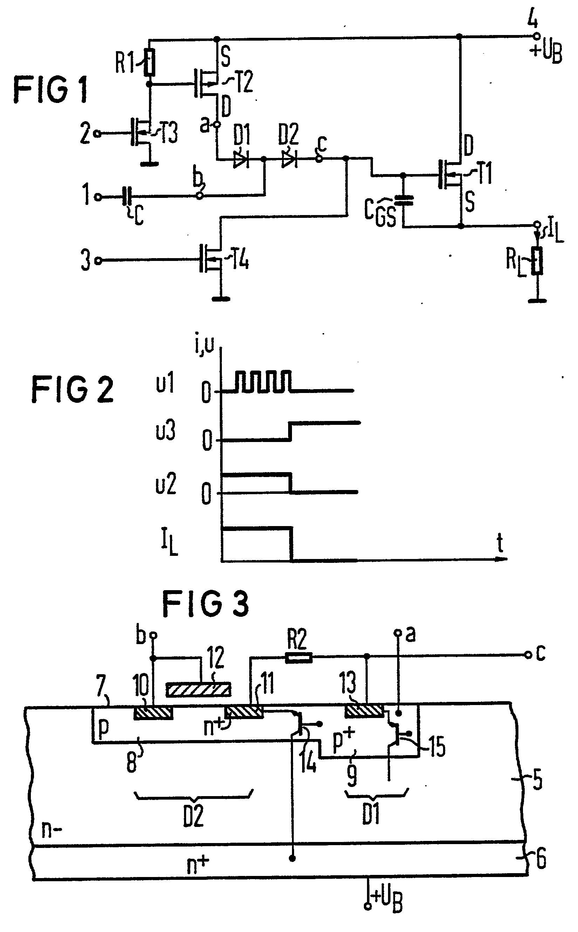

Der als Sourcefolger betriebene MOSFET in der Schaltungsanordnung nach Fig. 1 ist mit T 1 bezeichnet. Ihm ist sourceseitig eine Last $R_L$ in Reihe geschaltet. Die Reihenschaltung liegt zwischen einer Ausgangsklemme 4 und Masse an einer Betriebsspannung $+U_B$. Der Transistor T 1 hat eine Gate-Source-Kapazität $C_{GS}$. Der Gateanschluß von T 1 ist über die Reihenschaltung zweier Dioden D 1, D 2 und die Source-Drainstrecke eines zweiten MOSFET T 2 mit der Klemme 4 der Schaltung verbunden. Der zweite MOSFET T 2 ist vom dem ersten MOSFET T 1 entgegengesetzten Kanaltyp. Im Ausführungsbeispiel ist T 1 vom n-Kanaltyp und T 2 vom p-Kanaltyp. Der Transistor T 2 ist sourceseitig mit der Klemme 4 verbunden.

Zwischen dem Sourceanschluß und dem Gateanschluß des Transistors T 2 liegt ein Widerstand R 1. Der Gateanschluß von T 2 liegt über einen weiteren MOSFET T 4 an Masse. Dieser ist vom gleichen Kanaltyp wie T 1 . Der Drainanschluß von T 4 liegt an Masse.

Die Reihenschaltung aus den beiden Dioden D 1 und D 2 ist mit einem Mittelabgriff versehen, der mit einem Anschluß eines Kondensators C verbunden ist. Der andere Anschluß des Kondensators ist mit einer Eingangsklemme 1 verbunden.

Der Gateanschluß des Transistors T 1 ist mit der Source-Drainstrecke eines weiteren MOSFET T 4 verbunden, der sourceseitig ebenfalls an Masse liegt. Der Gateanschluß dieses Transistors ist mit einer Eingangsklemme 3 verbunden.

Zum Einschalten des Transistors T 1 werden auf die Eingangsklemmen die in Fig. 2 mit u 1, u 2 und u 3 bezeichneten Spannungen gegeben. Dabei ist u 1 eine getaktete Gleichspannung, deren Hub beispielsweise der Betriebsspannung entsprechen kann. Die Spannungen u 2 und u 3 sind beispielsweise Ausgangssignale einer Logikschaltung mit den Pegeln L = 0 V und H = 5 V. Diese Signale sind einander invers.

Während an der Eingangsklemme 1 die getaktete Spannung anliegt, ist also die Spannung u 3 = L und die Spannung u 2 an der Klemme 2 = H. Damit ist der Transistor T 4 gesperrt und der Transistor T 3 geöffnet. Es fließt damit ein Strom von der Klemme 4 durch den Transistor T 2, die Diode D 1 in den Kondensator C. Dieser wird damit auf die Betriebsspannung +U$_B$ aufgeladen. Mit jedem Takt der Spannung u 2 erhöht sich die Ladung des Kondensators C, so daß er auf eine Spannung aufgeladen wird, die höher ist als die Betriebsspannung +U$_B$. Der Kondensator C entlädt sich daher ständig in die Gate-Source-Kapazität C$_{GS}$ von T 1 und steuert diesen dauernd leitend. Damit kann ein Laststrom I$_L$ von der Klemme +U$_B$ nach Masse fließen.

Soll der Transistor T 1 ausgeschaltet werden, wird die Spannung an der Eingangsklemme 1 zu Null, die Spannung u 3 geht nach H und die Spannung u 2 nach L. Damit wird der MOSFET T 3 eingeschaltet und entlädt die Kapazität C$_{GS}$. Gleichzeitig wird der MOSFET T 2 gesperrt, so daß ein Nachladen des Kondensators C unterbleibt.

Die Schaltungsanordnung nach Fig. 1 ist auf einfache Weise integrierbar, wobei die Integration der MOSFET in der Technik der integrierten Schaltkreise durchgeführt werden kann. Auf eine gesonderte Darstellung der integrierten MOSFET sowie des integrierten Widerstands und Kondensators wird daher verzichtet. In Fig. 3 ist daher lediglich die integrierte Anordnung der Dioden D 1 und D 2 dargestellt.

Die Dioden sind in einen Halbleiterkörper integriert, der als Substrat eine erste Zone 5 aufweist. An diese schließt sich auf einer Seite eine stärker dotierte Zone 6 an, die mit der Betriebsspannung +U$_B$ verbunden wird. In die erste Zone 5 ist eine Zone 7 vom entgegengesetzten Leitungstyp planar eingebettet. Diese Zone besteht aus zwei Teilen 8 und 9. Der Teil 9 ist höher dotiert als der Teil 8 und dicker als dieser. In den Teil 8 sind eine Drainzone 10 und eine Sourcezone 11 eingebettet. Dazwischen tritt der Teil 8 an die Oberfläche des Halbleiterkörpers und ist dort von einer Gateelektrode 12 überdeckt. Die Zone 8 bildet dort die Gatezone eines lateralen MOSFET. Die Gateelektrode 11 ist mit der Drainzone 10 und einem Anschluß b verbunden. In den Teil 9 ist eine Zone 13 eingebettet, die die Katode der Diode D 1 ist. Die Anodenzone wird durch den Teil 9 gebildet, der mit einem Anschluß a versehen ist. Die Sourcezone 11 und die Katodenzone 13 der Diode D 1 ist über einen Widerstand R 2 miteinander und mit einem Anschluß c verbunden. Die Bezeichnung der Anschlüsse entspricht der nach Fig. 2.

Der Lateral-MOSFET bildet die Diode D 2, während die Diode D 1 durch die Zone 13 und den Teil 9 gebildet ist. Wird an den Anschluß b eine Spannung angelegt, so öffnet der Lateral-MOSFET und es fließt ein Strom von der Zone 10 durch den Teil 8 in die Zone 11 zum Anschluß c. Wird an den Anschluß a eine Spannung angelegt, so fließt Strom in den Teil 9 und über die Zone 13 zum Anschluß c.

Die Zone 13 bildet den Teil 9 und der Zone 5 einen parasitären Bipolartransistor 15, während die Zone 11 mit dem Teil 8 und der Zone 5 einen parasitären Bipolartransistor 14 bildet. Die Wirkung des parasitären Bipolartransistors 15 wird weitgehend durch die hohe Dotierung des Teils 9 und durch die größere Dicke gegenüber dem Teil 8 eliminiert, woraus eine relativ geringe Stromverstärkung resultiert (ß = 10 ... 50). Die Wirkung des parasitären Bipolartransistors 14 wird durch den Widerstand R 2 begrenzt. Es ist im Prinzip jedoch auch hier möglich, den Teil 8 dicker auszuführen, bezüglich der Höhe der Dotierung sind hier jedoch Grenzen gesetzt, weil eine niedrige Einsatzspannung des Lateral-MOSFET erwünscht ist. Es ist auch möglich, die Teile 8 und 9 als voneinander getrennte Zonen auszubilden.

## Patentansprüche

1. Schaltungsanordnung zum Ansteuern eines MOSFET mit einer Last, die zwischen dem Sourceanschluß und Masse liegt, mit dem Merkmalen:
a) Der Drainanschluß des MOSFET ist mit einer Ausgangsklemme verbunden,
b) die Ausgangsklemme ist mit einem Pol einer Betriebsspannungsquelle verbindbar,
c) zwischen dem Gateanschluß des MOSFET und Masse liegt ein Schalter,
d) in der Gatezuleitung des MOSFET liegen zwei in Reihe geschaltete Dioden,
e) die Reihenschaltung ist mit einem Mittelabgriff versehen, der mit einem Anschluß eines Kondensators versehen ist,
f) der andere Anschluß ist mit einer ersten Anschlußklemme verbunden, an die eine getaktete Gleichspannung anlegbar ist,
gekennzeichnet durch die Merkmale:
g) die Reihenschaltung der Dioden (D 1, D 2) ist über die Drain-Sourcestrecke eines zweiten MOSFET (T 2) mit der genannten Ausgangsklemme (4) verbunden,
h) der zweite MOSFET ist vom dem ersten MOSFET (T 1) entgegengesetzten Kanaltyp und sourceseitig mit der Ausgangsklemme (4) verbunden,
i) zwischen Sourceanschluß und dem Gateanschluß des zweiten MOSFET liegt ein Widerstand (R 1),
k) zwischen Gateanschluß des zweiten MOSFET und Masse liegt die Source-Drainstrecke eines dritten MOSFET (T 3) vom dem ersten MOSFET entsprechenden Kanaltyp,
l) der Gateanschluß des dritten MOSFET ist mit einer zweiten Eingangsklemme (2) verbunden,
m) der Schalter wird durch einen vierten MOSFET (T 4) vom dem ersten MOSFET entsprechenden Kanaltyp gebildet,
n) der Gateanschluß des vierten MOSFET ist mit einer dritten Eingangsklemme (3) verbunden,
o) an die zweite und dritte Eingangsklemme (2, 3) sind einander inverse logische Signale anlegbar.

2. Integrierte Schaltungsanordnung der Dioden nach Anspruch 1, gekennzeichnet durch ein Halbleitersubstrat (5), in das ein lateraler MOSFET mit einer Sourcezone (11), einer Drainzone (10) und einer Gatezone (8) eingebettet ist, dessen Gateelektrode (12) mit der Drainzone (10) verbunden ist, durch einen vertikalen Bipolartransistor mit einer Emitterzone (13), einer Basiszone (9), einer durch das Substrat (5) gebildeten Kollektorzone und mit niedriger Stromverstärkung, durch einen zwischen Sourcezone und Emitterzone liegenden Widerstand (R 2) und durch einen Anschluß (a) an der Basiszone (9).

3. Integrierte Schaltungsanordnung nach Anspruch 2, dadurch gekennzeichnet, daß die Gatezone (8) und die Basiszone (9) eine einzige, zusammenhängende Zone bilden.

4. Integrierte Schaltungsanordnung nach Anspruch 3, dadurch gekennzeichnet, daß die Basiszone (8) dicker ist und höher dotiert ist als die Gatezone (9).

## Claims

1. Circuit arrangement for driving a MOSFET having a load connected between the source terminal and ground, having the features:
a) the drain terminal of the MOSFET is connected to an output terminal,
b) the output terminal can be connected to one polarity of an operating voltage source,
c) there is a switch between the gate terminal of the MOSFET and ground,
d) there are two diodes connected in series in the gate line of the MOSFET,
e) the series circuit is provided with a central tap which is provided with one terminal of a capacitor,
f) the other terminal is connected to a first terminal, to which a clocked d.c. voltage can be applied, characterized by the features:
g) the series circuit of the diodes (D 1, D 2) is connected to the aforesaid output terminal (4) via the drain-source path of a second MOSFET (T 2),
h) the second MOSFET is of a channel type opposite to that of the first MOSFET (T 1) and its source terminal is connected to the output terminal (4),
i) a resistor (R 1) is connected between source terminal and the gate terminal of the second MOSFET,
k) the source-drain path of a third MOSFET (T 3) of a channel type corresponding to the first MOSFET is connected between gate terminal of the second MOSFET and ground,
l) the gate terminal of the third MOSFET is connected to a second input terminal (2),
m) the switch is formed by a fourth MOSFET (T 4) of a channel type corresponding to the first MOSFET,
n) the gate terminal of the fourth MOSFET is connected to a third input terminal (3),
o) inversely related logical signals can be applied to the second and third input terminal (2, 3).

2. Integrated circuit arrangement of the diodes according to claim 1, characterized by a semiconductor substrate (5), in which a lateral MOSFET having a source zone (11), a drain zone (10) and a gate zone (8) is embedded, the gate electrode (12) of which is connected to the drain zone (10); by a vertical bipolar transistor having an emitter zone (13), a base zone (9), a collector zone formed by the substrate (5), and having low current amplification; by a resistor (R 2) connected between source zone and emitter zone; and by a terminal (a) at the base zone (9).

3. Integrated circuit arrangement according to claim 2, characterized in that the gate zone (8) and the base zone (9) form a single, continuous zone.

4. Integrated circuit arrangement according to claim 3, characterized in that the base zone (8) is thicker and more heavily doped than the gate zone (9).

## Revendications

1. Montage pour l'attaque d'un MOSFET avec une charge, qui est situé entre la borne de source et la masse, comportant les particularités suivantes:
a) la borne de drain du MOSFET est reliée à une borne de sortie,
b) la borne de sortie est susceptible d'être reliée à un pôle d'une source de tension de fonctionnement,
c) entre la borne de grille du MOSFET et la masse se trouve un interrupteur,
d) dans le conducter menant à la grille du MOSFET se situent deux diodes montées en série,
e) le montage en série est pourvu d'une prise médiane qui est pourvue d'une borne de raccordement d'un condensateur,
f) l'autre borne est reliée à une première borne de raccordement à laquelle est susceptible d'être appliquée une tension continue cadencée, caractérisé par les moyens suivants:
g) le montage en série des diodes (D 1, D 2) est relié à la borne de sortie sus-mentionnée (4), par l'intermédiaire du circuit drain-source d'un second MOSFET (T 2),
h) le second MOSFET est d'un type de canal qui est opposé à celui du premier MOSFET (T 1), et il est relié, côté source, à la borne de sortie (4),
i) entre la borne de source et la borne de grille du second MOSFET, est prévue une résistance (R1),
k) entre la borne de grille du second MOSFET et la masse, est situé le circuit source-drain d'un troisième MOSFET (T 3) d'un type de canal qui correspond à celui du premier MOSFET,
l) la borne de grille du troisième MOSFET est reliée à une seconde borne d'entrée (2),
m) l'interrupteur est constitué par un quatrième MOSFET (T 4) d'un canal qui est du type qui correspond à celui du premier MOSFET,
n) la borne de grille du quatrième MOSFET est reliée à une troisième borne d'entrée (3),
o) à la seconde borne d'entrée et à la troisième borne d'entrée (2, 3) sont susceptibles d'être appliqués des signaux logiques qui sont inverses l'un de l'autre.

2. Montage intégré des diodes selon la revendication 1, caractérisé par un substrat semiconducteur (5) dans lequel est noyé un MOSFET latéral avec une zone de source (11), avec une zone de drain (10) et une zone de grille (8), dont l'électrode de grille (12) est reliée à la zone de drain (10) par un transistor bipolaire vertical avec une zone d'émetteur (13), une zone de base (9), une zone de collecteur formée par le substrat (5) et avec une faible amplification du courant par une résistance (R 2) qui est située entre la zone de source et la zone d'émetteur et par une borne (a) de la zone de base (9).

3. Montage intégré selon la revendication 2, caractérisé par le fait que la zone de grille (8) et la zone de base (9) forment une zone unique et d'un seul tenant.

4. Montage intégré selon la revendication 3, caractérisé par le fait que la zone de base (8) est plus épaisse et est plus fortement dopée que la zone de grille (9).

**FIG 1**

**FIG 2**

**FIG 3**